# EUROPÄISCHE PATENTSCHRIFT

(11) **EP 0 520 294 B1**
(45) Veröffentlichungstag und Bekanntmachung des Hinweises auf die Patenterteilung: **26.08.1998**
(21) Anmeldenummer: 92110136.6
(22) Anmeldetag: 16.06.1992
(51) Int. Cl.: H01L 23/373, H01L 23/492

(54) **Halbleiterbauelement und Verfahren zu seiner Herstellung**
Semiconductor device and method of manufacturing the same
Composant semi-conducteur et son procédé de fabrication

(30) Priorität: 24.06.1991 DE 4120827
(43) Veröffentlichungstag der Anmeldung: 30.12.1992
(73) Patentinhaber: SIEMENS AKTIENGESELLSCHAFT, 80333 München (DE)
(72) Erfinder: Kuhnert, Reinhold, Dr. rer.nat., W-8000 München 19 (DE); Türkes, Peter, Dr. rer.nat., W-8025 Unterhaching (DE)

(56) Entgegenhaltungen:
- EP-A- 0 242 626
- DE-A- 3 731 624
- FR-A- 2 636 777
- BROWN BOVERI REVIEW. Bd. 74, Nr. 11, November 1987, BADEN CH Seiten 613 - 619; P.LEIPOLD ET AL.: 'Reliability Tests for Power Semiconductor Modules'

## Beschreibung

Die Erfindung bezieht sich auf ein Halbleiterbauelement nach dem Oberbegriff des Patentanspruchs 1 und auf Verfahren zu seiner Herstellung.

Ein Halbleiterbauelement dieser Art ist zum Beispiel aus der französischen Anmeldeschrift FR 2 636 777-A1 bekannt, bei der der Halbleiterkörper über eine thermisch gut leitende Isolierschicht direkt mit einem Zusatzkörper verbunden ist.

Die Befestigung eines großflächigen leistungshalbleiters auf einem Substrat mit einer Silberpaste durch Drucksintern ist aus der EP-A-0 242 626 bekannt. Bei leistungshalbleitern muß häufig von einer kurzzeitigen thermischen Belastung ausgegangen werden, die etwa beim Einsatz eines solchen Bauelements als Schalter in einem Laststromkreis vorhanden ist. Eine derartige impulsförmige Belastung kann über der zulässigen Dauerbelastung liegen, ohne daß es hierdurch zu einer Zerstörung des Bauelements kommt, sofern die thermischen Belastungsimpulse zu einer Temperatur des Halbleiterbauelements führen, die einen Maximalwert auch kurzzeitig nicht übersteigt.

Aus der deutschen Offenlegungsschrift DE 37 31 624 A1 ist ein Leistungshalbleitermodul bekannt, bei dem auf ein Chip eine Ausgleichsronde und ein Kupferanschlußelement gelötet sind, die neben der Funktion als Stromzuführung auch als Wärmepuffer wirken, obwohl diese Wirkung in der obengenannten Schrift nicht explizit angegeben ist.

Der Erfindung liegt die Aufgabe zugrunde, ein Halbleiterbauelement der eingangs genannten Art anzugeben, dessen impulsförmige thermische Belastbarkeit wesentlich über der von herkömmlichen Bauelementen dieser Art liegt oder deren Erwärmung bei vergleichbaren thermischen Belastungen wesentlich kleiner ist als die der bekannten Bauelemente. Das wird erfindungsgemäß durch eine Ausbildung nach dem kennzeichnenden Teil des Patentanspruchs 1 erreicht.

Der mit der Erfindung erzielbare Vorteil besteht insbesondere darin, daß die Erwärmung des Halbleiterbauelements unter Zugrundelegung der thermischen Belastungsimpulse wesentlich niedriger ist als bei herkömmlichen Bauelementen, so daß gegenüber den letzteren entweder eine höhere impulsförmige thermische Belastung oder eine höhere Dauerbetriebstemperatur zugelassen werden können.

Bevorzugte Ausgestaltungen und Weiterbildungen der Erfindung sind in den Patentansprüchen 2 bis 5 angegeben. Die Patentansprüche 6 und 7 sind auf bevorzugte Verfahren zur Herstellung von Halbleiterbauelementen nach der Erfindung gerichtet.

Die Erfindung wird nachfolgend anhand von in der Zeichnung dargestellten, bevorzugten Ausführungsbeispielen näher erläutert. Dabei zeigen:
- Figur 1: ein Ausführungsbeispiel außerhalb der Erfindung,
- Figur 2: ein Ausführungsbeispiel der Erfindung,
- Figur 3: eine Weiterbildung des Ausführungsbeispiels nach Figur 1,
- Figur 4: eine Darstellung zur Erläuterung eines ersten Herstellungsverfahrens für ein Halbleiterbauelement nach der Erfindung,
- Figur 5: eine Darstellung zur Erläuterung eines zweiten Herstellungsverfahrens für ein Halbleiterbauelement nach der Erfindung und
- Figur 6: eine Darstellung zur Erläuterung eines zusätzlichen Verfahrensschrittes bei der Herstellung eines Halbleiterbauelements nach Figur 2.

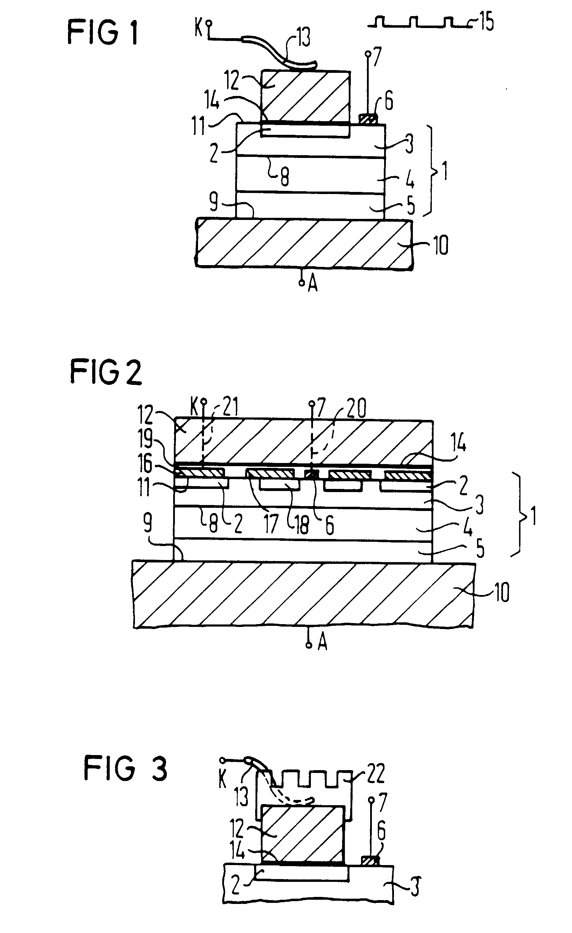

In Figur 1, die nicht unter die Erfindung fällt, ist der Halbleiterkörper 1 eines Halbleiterbauelements im Schnitt dargestellt. Es handelt sich beispielsweise um einen Thyristor, der eine vertikale npnp-Schichtenfolge aufweist. Die einzelnen Schichten werden als n-Emitter 2, p-Basis 3, n-Basis 4 und p-Emitter 5 bezeichnet. Die p-Basis 3 ist mit einem Gatekontakt 6 versehen, der einen Anschluß 7 zur Zuführung eines Zündstromimpulses aufweist. Ein die p-Basis 3 von der n-Basis 4 trennender pn-Übergang ist mit 8 bezeichnet. Der Halbleiterkörper 1 ist mit seiner Unterseite 9 auf einem metallischen Substrat 10 befestigt, das beispielsweise aus Molybdän besteht und mit einem anodenseitigen Anschluß A versehen ist. Auf der Oberseite 11 von Halbleiterkörper 1 ist ein blockförmiger Zusatzkörper 12 angebracht, der aus einem Metall großer Wärmeleitfähigkeit besteht und als Wärmepuffer dient. Er kann mit besonderem Vorteil aus Kupfer, Wolfram oder Molybdän gefertigt sein. Der Zusatzkörper 12 ist in Figur 1 als eine den n-Emitter 2 kontaktierende Elektrode ausgebildet und mit einer kathodenseitigen Zuleitung 13 verbunden, die mit einem kathodenseitigen Anschluß K versehen ist.

Zwischen der Oberseite 11 des Halbleiterkörpers 1 und der Unterseite des Zusatzkörpers 12 ist eine Verbindungsschicht 14 vorgesehen, die einen sehr kleinen thermischen Übergangswiderstand zwischen dem n-Emitter 2 und dem Zusatzkörper 12 gewährleistet. Hierbei handelt es sich vorzugsweise um eine Silberschicht, die beim Verbinden der Teile 1 und 12 mittels eines Drucksinterverfahrens entsteht. Andererseits kann die Verbindungsschicht 14 auch bei Anwendung eines Diffusionsschweißverfahrens zur Verbindung der Teile 1 und 12 aus den Kontaktierungsschichten gebildet werden, die jeweils auf die miteinander zu verbindenden Flächen aufgebracht werden. Drucksinterund Diffusionsschweißverfahren, die mit Vorteil zur Verbindung der Teile 1 und 12 herangezogen werden können, werden weiter unten eingehend beschrieben.

Befindet sich der Thyristor 1 in einem bei A und K angeschlossenen Laststromkreis, der neben einer Wechselspannungsquelle einen Lastwiderstand enthält, und führt man dem Anschluß 7 eine periodische Folge von Zündstromimpulsen 15 zu, so schaltet der Thyristor 1 beim Auftreten jedes einzelnen Zündstromimpulses in den leitenden Zustand, in dem die Anordnung 10, 1, 12 von einem Laststrom durchflossen wird. Beim Auftreten des auf jeden Zündstromimpuls folgenden Nulldurchgangs der Wechselspannung wird der Thyristor 1 wieder gelöscht, so daß eine Folge von Laststromimpulsen entsteht, deren Folgefrequenz durch die Zündstromimpulse 15 bestimmt wird. Die Laststromimpulse ergeben dann eine periodische, pulsförmige thermische Belastung der aus den Teilen 1, 10 und 12 bestehenden Anordnung, die zu einer konstanten Grundtemperatur der Anordnung führt. Durch den Zusatzkörper 12, der einen Wärmepuffer (heat buffer) darstellt, ist die Wärmekapazität dieser Anordnung so groß, daß die zusätzliche Erwärmung des Thyristors 1 beim Auftreten von zusätzlichen thermischen Belastungsimpulsen wesentlich niedriger ist als bei vergleichbaren herkömmlichen Thyristoren, die lediglich aus den Teilen 1 und 10 bestehen. Daher kann bei einer Anordnung nach Figur 1 eine höhere impulsförmige thermische Belastung als bei herkömmlichen Thyristoren zugelassen werden, ohne daß eine vorgegebene maximale Bauelementetemperatur überschritten wird. Das bedeutet beispielsweise, daß die Dauer der einzelnen Belastungsimpulse größer werden kann als das bisher möglich war. Andererseits kann bei gleicher Dauer der Belastungsimpulse die darin freigesetzte Wärme größer werden, ohne daß die maximale Bauelementetemperatur überschritten wird.

Die in Figur 1 gezeigte Ausbildung des Zusatzkörpers 12 als großflächiger elektrischer Kontakt trägt zur Homogenisierung des zwischen A und K fließenden Laststroms bei. Außerdem kann die mit dem Zusatzkörper 12 verbundene Zuleitung 13 mit einem hinreichend großen Querschnitt ausgebildet werden, so daß das bei großen Lastströmen übliche Mehrfachbondverfahren, bei dem mehrere dünne Zuleitungen parallel zueinander mit ein und derselben Elektrodenstruktur verbunden werden, vermieden wird.

Während bei dem in Figur 1 dargestellten Ausführungsbeispiel der Zusatzkörper 12 als eine einen stromführenden Bereich der Oberseite 11 des Halbleiterkörpers 1 kontaktierende, großflächige Elektrode ausgebildet ist, zeigt Figur 2 einen Thyristor, bei dem auf der Oberseite des Halbleiterkörpers 1 großflächige leitende Belegungen vorgesehen sind, so daß eine elektrodenartige Ausbildung des Zusatzkörpers im Bereich dieser Belegungen 5 nicht in Frage kommt. Die leitenden Belegungen bestehen im einzelnen aus einer kathodenseitigen Elektrode 16, die den n-Emitter 2 kontaktiert, aus einer Belegung 17, die ein in die p-Basis 3 eingefügtes n-leitendes Gebiet 18 kontaktiert und zusammen mit diesem einen Hilfsemitter (amplifying gate) bildet, der eine innere Zündverstärkung des Thyristors darstellt, und aus der zentral angeordneten Gateelektrode 6. Der Zusatzkörper 12 wird hier auf einer dünnen Isolierschicht 19 befestigt, die die leitenden Belegungen 6, 16 und 17 elektrisch isoliert und vorzugsweise aus Siliziumnitrid (Si₃N₄) oder aus amorphem Kohlenstoff besteht. Zwischen dem Zusatzkörper 12 und der dünnen Isolierschicht 19 befindet sich noch die Verbindungsschicht 14 aus Silber, die bei Heranziehung eines Drucksinterverfahrens zum Verbinden der Teile 1 und 12 gebildet wird oder aus zwei Kontaktierungsschichten entsteht, welche vor Durchführung eines Diffusionsschweißverfahrens jeweils auf der Oberseite der dünnen Isolierschicht 19 und auf der Unterseite des Zusatzkörpers 12 aufgebracht werden. Die Verbindungsschicht 14 sorgt dabei für einen thermischen Übergangswiderstand zwischen den Teilen 1 und 12, der zwar größer ist als bei dem Thyristor nach Figur 1, doch noch toleriert werden kann. Die Zuleitungen 20 und 21 zu den Teilen 6 und 16 befinden sich vor oder hinter dem Zusatzkörper 12, was durch ihren gestrichelten Verlauf angedeutet ist, und sind mit den Anschlüssen 7 und K versehen.

Figur 3 zeigt eine Weiterbildung des Halbleiterbauelements nach Figur 1, bei der der Zusatzkörper 12 mit einem aufgesteckten Kühlblech 22 versehen ist. Hierdurch wird die Gleichstrombelastbarkeit des Halbleiterbauelements erhöht.

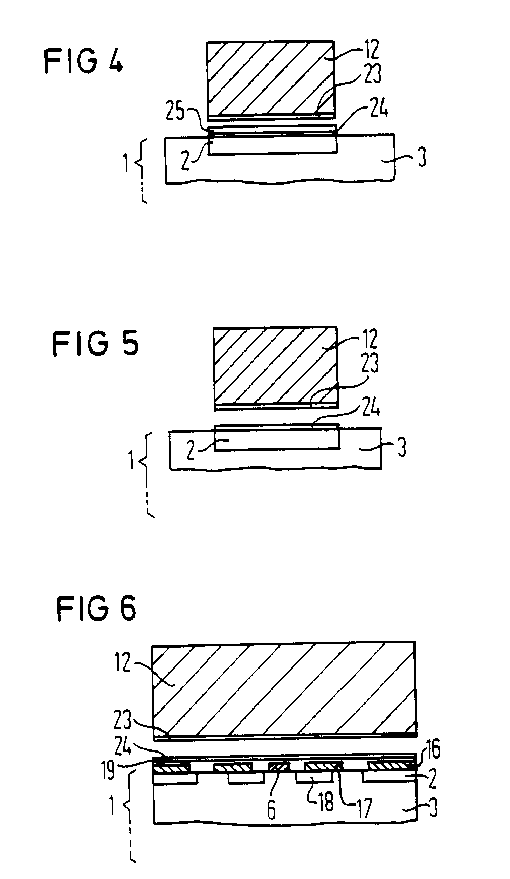

Bei einem Halbleiterbauelement nach Figur 1 erfolgt die Verbindung der Teile 1 und 12 vorzugsweise nach einem an sich bekannten, als Drucksintern bezeichneten Verfahren der Niedertemperaturverbindungstechnik, das anhand von Figur 4 näher erläutert wird. Dabei wird der Zusatzkörper 12 wenigstens an seiner Unterseite mit einer galvanisch aufgetragenen Kontaktierungsschicht 23 versehen, die etwa 2 bis 3 µm dick ist und aus Silber besteht. Die Oberseite des Halbleiterkörpers 1 wird im Bereich des n-Emitters 2 mit einer Schichtfolge überzogen, die aus einer etwa 1 µm starken Aluminiumschicht, einer auf dieser aufgetragenen, etwa 100 nm dicken Titanschicht, einer über dieser liegenden, etwa 500 nm dicken Mittelschicht, zum Beispiel aus Nickel oder Platin, und schließlich einer diese abdeckenden, etwa 200 nm starken Silberschicht besteht. In Figur 4 ist lediglich die als Kontaktierungsschicht dienende Silberschicht dargestellt und mit 24 bezeichnet. Anschließend wird auf der Kontaktierungsschicht 24 eine Paste 25 schichtförmig, und zwar mit einer Schichtdicke von etwa 10 bis 100 µm, vorzugsweise etwa 20 µm, aufgetragen. Als Ausgangsstoff für die Herstellung der Paste 25 wird Silberpulver verwendet, das in Cyclohexanol als Lösungsmittel suspendiert wird. Anschließend wird die so hergestellte Paste im Vakuum entgast, um beim Trocknen eine Lunkerbildung zu vermeiden.

Nach dem Trocknen der Paste 25 wird der Zusatzkörper 12 mit seiner Kontaktierungsschicht 23 auf die von der Paste 25 bedeckte Kontaktierungsschicht 24 des Halbleiterkörpers 1 aufgesetzt und die aus den Teilen 1 und 12 bestehende Anordnung auf eine Sintertemperatur von zum Beispiel 230°C gebracht. Bei dieser Temperatur wird auf die Anordnung 1, 12 während einer Sinterzeit von etwa 1 Minute ein Druck von mindestens 900 N/cm² ausgeübt. Es ist jedoch darauf hinzuweisen, daß bereits bei Sinterzeiten von einigen Sekunden eine ausreichende Verbindung der genannten Teile erreicht wird und daß der Druck auch auf 1 bis 2 t/cm² gesteigert werden kann. Die Sintertemperatur kann in einem Bereich liegen, der einen unteren Grenzwert von etwa 150°C und einen oberen Grenzwert von etwa 250°C aufweist. Weiterhin ist hervorzuheben, daß das Drucksintern in normaler Atmosphäre vorgenommen wird, das heißt eine Anwendung von Schutzgas nicht erforderlich ist. Die Paste 25 kann auch zusätzlich oder ausschließlich auf der Kontaktierungsschicht 23 aufgetragen werden.

Ein weiteres, für die Verbindung der Teile 1 und 12 geeignetes Verfahren der Niedertemperaturverbindungstechnik ist das Diffusionsschweißen, das anhand von Figur 5 beschrieben wird. Dabei wird der Zusatzkörper 12 an seiner Unterseite mit der Kontaktierungsschicht 23 versehen, während die Oberseite des Halbleiterkörpers 1 im Bereich des n-Emitters 2 mit einer Edelmetall-Kontaktierungsschicht 24 versehen wird, die aus Silber besteht. Es ist vorteilhaft, unter der Kontaktierungsschicht 24 metallische Zwischenschichten, zum Beispiel aus Al, Ag, Cu oder Au, mit einer Schichtdicke von etwa 10 bis 20 µm vorzusehen. Diese Zwischenschichten sind plastisch verformbar, um die Rauhtiefen der miteinander zu verbindenden Flächen auszugleichen.

Die in dieser Weise beschichteten Teile 1 und 12 werden nun so aufeinandergesetzt, daß die Unterseite des Zusatzkörpers 12 die Kontaktierungsschicht 24 des Halbleiterkörpers berührt. Anschließend werden die Teile 1 und 12 auf eine Temperatur gebracht, die etwa im Bereich von 150 bis 250°C liegt, also in einem gemäßigten Temperaturbereich, der mit der Betriebstemperatur eines Leistungshalbleiters vergleichbar ist. Dabei werden diese Teile mit einem Anpreßdruck von etwa 5 bis 25 kN/cm² (500 bis 2500 Kp/cm²) oder darüber während einer Diffusionszeit von einigen Minuten zusammengepreßt. Aber auch bei Diffusionszeiten von nur wenigen Sekunden werden schon ausreichende Ergebnisse erzielt. Andererseits kann der Druck auf über 2,5 t/cm² gesteigert werden. Auch das Diffusionsschweißen erfolgt zweckmäßigerweise in einer normalen Atmosphäre ohne die Anwendung eines Schutzgases.

Figur 6 läßt erkennen, daß bei der Herstellung eines Halbleiterbauelements nach Figur 2 auf der Oberseite des Halbleiterkörpers 1 zunächst die die leitenden Belegungen 6, 16 und 17 abdeckende, dünne Isolierschicht 19 aufgebracht wird, die dann mit der Kontaktierungsschicht 24 überzogen wird. Anschließend erfolgt die Verbindung des insoweit beschichteten Halbleiterkörpers 1 mit dem mit einer Kontaktierungsschicht 23 versehenen Zusatzkörper 12, und zwar entweder nach dem Diffusionsschweißverfahren oder unter Verwendung der Paste 25 mittels des Drucksinterverfahrens.

Die Erfindung ist ganz allgemein auf alle Halbleiterbauelemente anwendbar, die in einem Halbleiterkörper monolithisch integriert sind, so beispielsweise auf Dioden, Thyristoren, Leistungstransistoren, Leistungs-MOSFETs, IGBTs usw. Die Zeichnungen können beispielsweise für die Darstellung von Dioden herangezogen werden, wenn der Halbleiterkörper 1 jeweils nur einen pn-Übergang 8 aufweist, der einen darüber liegenden, n-leitenden Bereich von einem darunter liegenden, p-leitenden Bereich trennt. Hierbei entfallen dann die Gateelektrode 6 und die leitenden Belegungen 16 und 17.

## Patentansprüche

1. Halbleiterbauelement mit einem Halbleiterkörper (1), der mit seiner Unterseite (9) auf einem metallischen Substrat (10) befestigt ist, bei dem auf der Oberseite (11) des Halbleiterkörpers (1) ein als Wärmepuffer dienender, aus einem Metall bestehender Zusatzkörper (12) aufgebracht ist, bei dem auf der Oberseite (11) des Halbleiterkörpers (1) leitende Belegungen (6, 16, 17) vorgesehen sind, die von einer dünnen elektrisch isolierenden Schicht (19) abgedeckt sind,
**dadurch gekennzeichnet,**
daß zwischen der dünnen, elektrisch isolierenden Schicht (19) und der Unterseite des Zusatzkörpers (12) eine Verbindungsschicht (14) aus Silber vorgesehen ist, wobei der Zusatzkörper und der Halbleiterkörper voneinander elektrisch isoliert sind und wobei der Zusatzkörper durch die Verbindungsschicht auf der elektrisch isolierenden Schicht befestigt ist und die Verbindungsschicht einen sehr kleinen thermischen Übergangswiderstand zwischen dem Zusatzkörper und der elektrisch isolierenden Schicht gewährleistet.

2. Halbleiterbauelement nach Anspruch 1,
**dadurch gekennzeichnet,**
daß der Zusatzkörper (12) aus einem Metall gefertigt ist, das zu einer Gruppe von Metallen gehört, die Kupfer, Wolfram und Molybdän enthält.

3. Halbleiterbauelement nach Anspruch 1,
**dadurch gekennzeichnet,**
daß die elektrisch isolierende Schicht (19) als eine Siliziumnitridschicht ausgebildet ist.

4. Halbleiterbauelement nach Anspruch 1,
**dadurch gekennzeichnet**,
daß die elektrisch isolierende Schicht (19) als eine amorphe Kohlenstoffschicht ausgebildet ist.

5. Halbleiterbauelement nach einem der Ansprüche 1 bis 4,
**dadurch gekennzeichnet,**
daß der Zusatzkörper (12) mit einem Kühlblech (22) versehen ist.

6. Verfahren zur Herstellung eines Halbleiterbauelements nach einem der vorhergehenden Ansprüche,
**dadurch gekennzeichnet,**
daß der Zusatzkörper (12) mittels eines Drucksinterverfahrens mit dem Halbleiterkörper (1) verbunden wird, wobei eine die Oberseite des Halbleiterkörpers (1) bedeckende Kontaktierungsschicht (24) aus Silber auf der die leitenden Belegungen (6, 16, 17) abdeckenden, elektrisch isolierenden Schicht (19) aufgebracht wird und eine aus einem Silberpulver und einem Lösungsmittel bestehende Paste (25) auf der mit der Kontaktierungsschicht (24) versehenen Oberseite des Halbleiterkörpers (1) und/oder auf der Unterseite des Zusatzkörpers (12) aufgetragen wird, die aufgetragene Paste (25) getrocknet wird, der Zusatzkörper (12) sodann mit seiner Unterseite auf die Oberseite des Halbleiterkörpers (1) aufgesetzt wird und diese Anordnung bei einer Sintertemperatur mit einem Druck von mindestens 900 N/cm² zusammengepreßt wird.

7. Verfahren zur Herstellung eines Halbleiterbauelements nach einem der Ansprüche 1 bis 5,
**dadurch gekennzeichnet,**
daß der Zusatzkörper (12) mittels eines Diffusionsschweißverfahrens mit dem Halbleiterkörper (1) verbunden wird, wobei eine die Oberseite des Halbleiterkörpers (1) bedeckende Kontaktierungsschicht (24) aus Silber auf der die leitenden Belegungen (6, 16, 17) abdeckenden, elektrisch isolierenden Schicht (19) aufgebracht wird und die Unterseite des Zusatzkörpers 812) mit einer Kontaktierungsschicht (24, 23) aus Silber versehen wird, der Zusatzkörper (12) sodann mit seiner Unterseite auf die Oberseite des Halbleiterkörpers (1) aufgesetzt wird und diese Anordnung bei gemäßigter Temperatur mindestens mit etwa 5 kN/cm² zusammengepreßt wird.

## Claims

1. Semiconductor device with a semiconductor body (1), which is fastened by its underside (9) on a metallic substrate (10), in which an additional body (12) is applied to the top side (11) of the semiconductor body (1), which additional body serves as a heat buffer and is composed of a metal, in which conductive coatings (6, 16, 17) are provided on the top side (11) of the semiconductor body (1) and are covered by a thin electrically insulating layer (19),
characterized in that a connecting layer (14) made of silver is provided between the thin electrically insulating layer (19) and the underside of the additional body (12), the additional body and the semiconductor body being electrically insulated from one another, and the additional body being fastened on the electrically insulating layer by the connecting layer, and the connecting layer ensuring a very small thermal contact resistance between the additional body and the electrically insulating layer.

2. Semiconductor device according to Claim 1, characterized in that the additional body (12) is produced from a metal belonging to a group of metals which contains copper, tungsten and molybdenum.

3. Semiconductor device according to Claim 1, characterized in that the electrically insulating layer (19) is designed as a silicon nitride layer.

4. Semiconductor device according to Claim 1, characterized in that the electrically insulating layer (19) is designed as an amorphous carbon layer.

5. Semiconductor device according to one of Claims 1 to 4,
characterized in that the additional body (12) is provided with a heat sink (22).

6. Method for producing a semiconductor device according to one of the preceding claims,
characterized in that the additional body (12) is connected to the semiconductor body (1) by means of a pressure sintering process, a contact-making layer (24), which is made of silver and covers the top side of the semiconductor body (1), being applied to the electrically insulating layer (19) covering the conductive coatings (6, 16, 17), and a paste (25) comprising a silver powder and a solvent being applied to the top side, provided with the contact-making layer (24), of the semiconductor body (1) and/or to the underside of the additional body (12), the applied paste (25) being dried, the additional body (12) then being placed by its underside onto the top side of the semiconductor body (1) and this arrangement being compressed at a pressure of at least 900 N/cm² at a sintering temperature.

7. Method for producing a semiconductor component according to one of Claims 1 to 5,
characterized in that the additional body (12) is connected to the semiconductor body (1) by means of a diffusion welding process, a contact-making layer (24), which is made of silver and covers the top side of the semiconductor body (1), being applied to the electrically insulating layer (19) covering the conductive coatings (6, 16, 17), and the underside of the additional body (12) being provided with a contact-making layer (24, 23) made of silver, the additional body (12) then being placed by its underside onto the top side of the semiconductor body (1) and this arrangement being compressed at least at about 5 kN/cm² at a moderate temperature.

## Revendications

1. Composant semi-conducteur comprenant un corps semi-conducteur (1) qui est fixé, avec son côté inférieur (9), sur un substrat métallique (10), dans lequel on applique, sur le côté supérieur (11) du corps semi-conducteur (1), un corps supplémentaire (12) formé d'un métal et servant de tampon thermique, dans lequel on prévoit, sur le côté supérieur (11) du corps semi-conducteur (1), des plaques conductrices (6, 16, 17) qui sont couvertes par une mince couche électriquement isolante (19), caractérisé en ce que l'on prévoit une couche de liaison (14) en argent entre la mince couche électriquement isolante (19) et le côté inférieur du corps supplémentaire (12), le corps supplémentaire et le corps semi-conducteur étant isolés électriquement l'un par rapport à l'autre, et le corps supplémentaire étant fixé sur la couche électriquement isolante par la couche de liaison et la couche de liaison garantissant une très faible résistance de contact thermique entre le corps supplémentaire et la couche électriquement isolante.

2. Composant semi-conducteur selon la revendication 1, caractérisé en ce que le corps supplémentaire (12) est fabriqué dans un métal appartenant à un groupe de métaux incluant le cuivre, le tungstène et le molybdène.

3. Composant semi-conducteur selon la revendication 1, caractérisé en ce que la couche électriquement isolante (19) est exécutée en tant que couche de nitrure de silicium.

4. Composant semi-conducteur selon la revendication 1, caractérisé en ce que la couche électriquement isolante (19) est exécutée en tant que couche de carbone amorphe.

5. Composant semi-conducteur selon l'une des revendications 1 à 4, caractérisé en ce que le corps supplémentaire (12) est pourvu d'une tôle de refroidissement (22).

6. Procédé de fabrication d'un composant semi-conducteur selon l'une des revendications précédentes, caractérisé en ce que le corps supplémentaire (12) est relié au corps semi-conducteur (1) au moyen d'un procédé de frittage sous pression, une couche de bonding (24) en argent couvrant le côté supérieur du corps semi-conducteur (1) étant appliquée sur la couche électriquement isolante (19) couvrant les plaques conductrices (6, 16, 17) et une pâte (25) formée d'une poudre d'argent et d'un solvant étant appliquée sur le côté supérieur du corps semi-conducteur (1) pourvu de la couche de bonding (24) et/ou sur le côté inférieur du corps supplémentaire (12), la pâte (25) appliquée étant séchée, le corps supplémentaire (12) étant ensuite posé, avec son côté inférieur, sur le côté supérieur du corps semi-conducteur (1) et cet ensemble étant pressé en étant soumis à une pression d'au moins 900 N/cm² en présence d'une température de frittage.

7. Procédé de fabrication d'un composant semi-conducteur selon l'une des revendications 1 à 5, caractérisé en ce que le corps supplémentaire (12) est relié au corps semi-conducteur (1) au moyen d'un procédé de soudage par diffusion, une couche de bonding (24) en argent couvrant le côté supérieur du corps semi-conducteur (1) étant appliquée sur la couche électriquement isolante (19) couvrant les plaques conductrices (6, 16, 17) et le côté inférieur du corps supplémentaire (12) étant pourvu d'une couche de bonding (24, 23) en argent, le corps supplémentaire (12) étant ensuite posé, avec son côté inférieur, sur le côté supérieur du corps semi-conducteur (1) et cet ensemble étant pressé en étant soumis à une pression d'au moins environ 5 kN/cm² en présence d'une température modérée.
